# EUROPEAN PATENT APPLICATION

(11) **EP 2 624 323 A1**
(43) Date of publication of application: **07.08.2013**
(21) Application number: 11828397.7
(22) Date of filing: 27.09.2011
(51) Int. Cl.: H01L 51/42

(54) **PHOTOELECTRIC CONVERSION ELEMENT**

(30) Priority: 29.09.2010 JP 2010218826
(71) Applicant: JX Nippon Oil & Energy Corporation, Chiyoda-ku Tokyo 100-8162 (JP)
(72) Inventor: NAKAYAMA, Keisuke, Tokyo 100-8162 (JP); GOTO, Masanao, Tokyo 100-8162 (JP)
(74) Representative: Algemeen Octrooi- en Merkenbureau
(86) International application number: PCT/JP2011/005406
(87) International publication number: WO 2012/042831

(57) **Abstract**

A photoelectric conversion element (10) is structured such that metallic particles (30), an isolation layer (40) and a photoelectric conversion layer (50) are held between a first electrode (20) and a second electrode (22). The isolation layer (40) is a hole transport layer. The photoelectric conversion layer (50) is a bulk heterojunction layer. The metallic nanoparticles (30) are two-dimensionally arranged between the first electrode (20) and the isolation layer (40) and are separated from the photoelectric conversion layer by the isolation layer (40) by 2 nm to 15 nm.

## Description

### [TECHNICAL FIELD]

The present invention relates to a photoelectric conversion element that converts light energy into electric energy by photoelectric conversion.

### [BACKGROUND ART]

An organic thin-film solar cell (thin-film photovoltaic cell), which is full of flexibility, can turn into a large area as a whole and be lightweight and thus it is expected that the organic thin-film solar cells are fabricated with ease and at low cost. Hence, the organic thin-film solar cells are considered to be a promising next generation solar cells. Improving the conversion efficiency to a significant level is presently an important issue to achieve the practical use of the organic film solar cells.

Penetration depth D of incident light in a photoelectric conversion layer of a solar cell is generally defined such that D=1/ 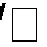 where 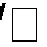 is the absorption coefficient of the photoelectric conversion layer. If the thickness of the photoelectric conversion layer is greater than D, a large part of incident light will be absorbed by the photoelectric conversion layer, so that a sufficient
photoelectric current can be obtained. If, on the other hand, the thickness of the photoelectric conversion layer is thinner than D, the photoelectric current will not be sufficiently obtained due to a drop in the amount of light absorbed thereby.

In the organic thin-film solar cell, the diffusion length of exciton produced in an organic semiconductor is short. Thus, even though the absorptance of incident light is increased by thickening the photoelectric conversion layer, excitons get deactivated during a process in which the excitons are diffused within thick film. This makes it difficult to efficiently retrieve the excitons as electric charges. As a result, the thickness of the photoelectric conversion layer must be thinner than D, thereby making it difficult to obtain a sufficient amount of light absorption.

To improve the light absorption in the thin-film solar cell, it is known in a conventional art that a texture structure having the size of wavelength of light is formed in the photoelectric conversion layer and thereby the light is trapped inside the photoelectric conversion layer. In the organic thin-film solar cell, the film thickness of the photoelectric conversion layer is less than the wavelength of light, so that such conventional art where the texture structure is formed in the photoelectric layer is not effective.

A research is underway in recent years where an attempt is made to improve the light absorption of the photoelectric conversion layer of the organic thin-film solar cell by directing attentions to an electric field enhancement effect resulting from the localized surface plasmon excitations of metallic nanoparticles.

### [Related Art List]

### [Patent documents]

[Patent document 1] Japanese Unexamined Patent Application Publication (Translation of PCT application) No. 2008-510305.

### [SUMMARY OF THE INVENTION]

### [PROBLEM TO BE SOLVED BY THE INVENTION]

Metallic nanoparticles has a much greater chance of improving the light absorption. It is to be noted, at the same time, that the energy absorbed by metallic nanoparticles is lost as thermal energy in a process in which light is absorbed by metallic nanoparticles. This may lead to a decrease of the light absorption in the photoelectric conversion layer. Also, the metallic nanoparticles may act as a recombination center of electrons and holes that are free carriers in the photoelectric conversion layer. In this case, the carrier collection efficiency deteriorates.

The present invention has been made to solve problems as described above, and a purpose thereof is to provide a technology by which to improve the light absorption of a photoelectric conversion element having a photoelectric conversion layer including an organic semiconductor.

### [MEANS TO SOLVE THE PROBLEMS]

One embodiment of the present invention relates to a photoelectric conversion element. The photoelectric conversion element includes: a photoelectric conversion layer including organic semiconductor; metallic nanoparticles; an isolation layer held between the metallic nanoparciles and the photoelectric conversion layer; a first electrode electrically connected to the photoelectric conversion layer on a side of a light-receiving surface of the photoelectric conversion layer; and a second electrode electrically connected to the photoelectric conversion layer on a side of the photoelectric conversion layer opposite to the light-receiving side thereof, wherein the metallic nanoparticles are separated from the photoelectric conversion layer by the isolation layer by 2 nm to 15 nm.

By employing the photoelectric conversion element according to the above-described embodiment, the electric field enhancement effect on account of the metallic nanoparticles is markedly produced, so that the utilization efficiency of solar energy can be further improved.

In the photoelectric conversion element according to the above-described embodiment, the isolation layer may be provided on the light-receiving surface of the photoelectric conversion layer, and the metallic nanoparticles may be provided on a surface of the isolation layer opposite to a surface thereof on a photoelectric conversion layer side. The isolation layer may be a charge transport layer. The metallic nanoparticles may be embedded in the photoelectric conversion layer, and the isolation layer may cover the metallic nanoparticles on a periphery thereof. An average particle size of the metallic nanoparticle may be 40 nm or blow. A total volume of the metallic nanoparticles over a volume of the photoelectric conversion layer may be in a range of 0.5 to 5 vol%. A light absorption peak wavelength 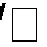 1 may be be larger than a surface plasmon resonance wavelength 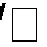 2. Also, the photoelectric conversion layer may be a bulk heterojunction layer.

It is to be noted that any arbitrary combinations or rearrangement, as appropriate, of the aforementioned constituting elements and so forth are all effective as the embodiments of the present invention and encompassed by the scope of the present invention.

### [ADVANTAGES OF THE PRESENT INVENTION]

The present invention improves the light absorptance of a photoelectric conversion element having a photoelectric conversion layer including an organic semiconductor.

### [BRIEF DESCRIPTION OF THE DRAWINGS]

FIG. 1 is a schematic cross-sectional view showing a structure of a photoelectric conversion element according to a first embodiment.
FIGS. 2A to 2D are cross-sectional views showing a process in a method for manufacturing a photoelectric conversion element according to a first embodiment.
FIGS. 3A and 3B are cross-sectional views showing a process in a method for manufacturing a photoelectric conversion element according to a first embodiment.
FIG. 4 is a schematic cross-sectional view showing a structure of a photoelectric conversion element according to a second embodiment.
FIG. 5 is a graph showing a quantum yield at each wavelength about a photoelectric conversion element of exemplary embodiment 1 where the quantum yield of a photoelectric conversion element according to comparative example 1 is set to unity.

### [BEST MODE FOR CARRYING OUT THE INVENTION]

Hereinbelow, the embodiments of the present invention will be described with reference to the accompanying drawings. Note that the identical components are given the identical reference numerals in all accompanying Figures and the repeated description thereof will be omitted as appropriate.

### (First Embodiment)

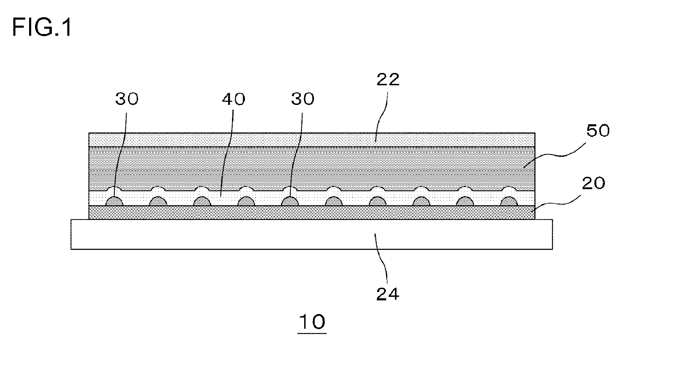

FIG. 1 is a schematic cross-sectional view showing a structure of a photoelectric conversion element 10 according to a first embodiment. The photoelectric conversion element 10 according to the present embodiment is an organic thin-film solar cell having a photoelectric conversion layer including an organic semiconductor.

The photoelectric conversion element 10 is structured such that metallic particles 30, an isolation layer 40 and a photoelectric conversion layer 50 are held between a first electrode 20 and a second electrode 22.

In the present embodiment, the first electrode 20, which is an anode, is electrically connected to a photoelectric conversion layer 50 described later. The first electrode 20 is located at a light-receiving surface side of the photoelectric conversion layer 50. The first electrode 20 is formed of a conductive metallic oxide (e.g., ITO (Indium Tin Oxide), SnO₂, ZnO, FTO (Fluorine doped Tin Oxide), AZO (Aluminum doped Zinc Oxide, and IZO (Indium doped Zinc Oxide)) and a transparent conductive film such as a metallic thin film (e.g., gold, silver, copper and aluminum). Also, the first electrode 20 is formed on top of a substrate 24, such as glass, having optical transparency in order not to obstruct a light-receiving performance. The substrate 24 may be not only colorless or colored glass, wire glass, glass block and the like but also colorless or colored resin having transparency. Specifically, such resin may be polyester, such as polyethylene terephthalate, polyamide, polysulfone, polyethersulfone, polyether ether ketone, polyphenylene sulfide, polycarbonate, polyimide, polymethylmethacrylate, polystyrene, triacetylcellulose, polymethylpentene, and the like.

A plurality of metallic nanoparticles 30 are two-dimensionally arranged between the first electrode 20 and the isolation layer 40. In other words, a plurality of metallic nanoparticles 30 are scattered in a two-dimensional array while the metallic nanoparticles 30 are in contact with a surface of the isolation layer 40 on a first electrode 20 side thereof.

The material used for the metallic particles 30 is not particularly limited as long as it is metallic material. Such material is preferably one for which the resonant frequency in the Frohlich mode is close to the wavelength of light with which the reflection can be prevented, and may be Au, Ag, Al, or Cu or an alloy of any combination of these metals. For the Frohlich mode, see a book entitled "Absorption and Scattering of Light by Small Particles" written by Bohren and Huffman and published by Wiley, 1983.

The shape of the metallic nanoparticle 30 is not limited to any particular shape and may be spherical, semispherical, cylindrical, prismatic, rod-like, disk-shaped or the like, for instance. An average particle size of the metallic nanoparticle 30 where viewed planarly from a direction perpendicular to the plane of the first electrode 20 may preferably be 40 nm or below, more preferably in a range of 3 to 30 nm, and still more preferably in a range of 5 to 15 nm. Also, the total volume of a plurality of metallic nanoparticles 30 over the volume of the photoelectric conversion layer 50 described later may preferably be in a range of 0.5 to 5 vol%, more preferably in a range of 0.6 to 3 vol%, and still more preferably in a range of 1.0 to 2.5 vol%.

The isolation layer 40 is provided on the light-receiving surface of the photoelectric conversion layer 50 and is held between the metallic nanoparticles 30 and the photoelectric conversion layer 50. The metallic nanoparticles 30 are separated from the photoelectric conversion layer 50 by the isolation layer by 2 nm to 15 nm.

In the present embodiment, the isolation layer 40 also serves as a hole transport layer that transports the holes from the photoelectric conversion layer 50 to the first electrode 20. The isolation layer 40 is formed of material having a high hole mobility. Such material used for the isolation layer 40 may be, for instance, a conductive polymer, such as polythiophene, polypyrrole, polyaniline, polyfuran, polypyridine, or polycarbazole, an organic dye molecule, such as phthalocyanine, porphyrin, or perylene and their derivatives or transit metal complexes, a charge transfer agent, such as a triphenylamine compound or hydrazine compound, or a charge-transfer complex, such as tetraliafulvalene (TTF). Where the isolation layer 40 also serves as the hole transport layer, the isolation layer 40 has a shallower LUMO level than the LUMO level of n-type semiconductor material used for the photoelectric conversion layer 50. This suppresses electrons generated in the photoelectric conversion layer 50 from moving to the first electrode 20, thus showing excellent rectification properties.

The photoelectric conversion layer 50 is a bulk heterojunction layer and is formed such that a p-type organic semiconductor having electron-donating property and an n-type organic semiconductor having electron accepting property are mixed together on a nano-scale level. The p-type organic semiconductor used herein may be an electron-donating molecule. Such an electron-donating molecule may be, for instance, polythiophene, such as poly(3-hexylthiophene), and its oligomer, an organic dye molecule, such as polypyrrole, polyaniline, polyfuran, polypyridine, polycarbazole, phthalocyanine, porphyrin, or perylene and their derivatives or transit metal complexes, a charge transfer agent, such as a triphenylamine compound or hydrazine compound, or a charge-transfer complex, such as tetraliafulvalene (TTF). The n-type organic semiconductor used herein may be an electron-accepting molecule. Such an electron-accepting molecule may be, for instance, fullerene, a fullerene derivative, such as phenyl-C61-butyric acid methyl ester (PCBM), a carbon material, such as carbon nanotube or chemically-modified carbon nanotube, or a perylene derivative.

A light absorption peak wavelength 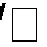 1 of the photoelectric conversion layer 50 is larger than a surface plasmon resonance wavelength 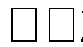 2 of the metallic nanoparticles 30. As a result, the light energy absorbed by the metallic nanoparticles 30 can be moved to the photoelectric conversion layer 50. Though the light absorption peak wavelength 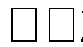 1 of the photoelectric conversion layer 50 varies depending on a material used, the light absorption peak wavelength 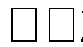 1 thereof is 520 nm if poly(3-hexylthiophene), made by Aldrich Chemical Company, Ltd., whose molecular weight is 17,500 is used as the p-type organic semiconductor while PCBM is used as the n-type organic semiconductor. The surface plasmon resonance wavelength 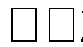 2 of the metallic nanoparticles 30 varies depending on the type of metal used, the surface plasmon resonance wavelength 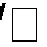 2 thereof is 340 nm if Al nanoparticles are used as the metallic particles 30, whereas it is 410 nm if Ag nanoparticles are used as the metallic particles 30.

The second electrode 22 of the present embodiment, which is a cathode, is electrically connected to the photoelectric conversion layer 50 on a side of the photoelectric conversion layer 50 opposite to the light-receiving side thereof. The material used for the second electrode 22 is not limited to any particular one as long as it is electrically conductive and may be, for instance, a metal such as gold, platinum, silver, copper, aluminum, magnesium, lithium, or potassium, or the second electrode 22 may be a carbon electrode, for instance. A method for installing the second electrode 22 may be a known method, such as a vacuum evaporation method, an electron beam vacuum evaporation method, a sputtering method, a method whereby metal fine particles dispersed in a solvent are applied and then the solvent is volatilized and removed. Also, various types of organic and inorganic materials can be formed in order that the adhesion, between the photoelectric conversion layer and a metallic layer including the second electrode 22, and an exciton-blocking property can be improved before the metallic layer including the second electrode 22 is formed. The material used herein is not limited to any particular one insofar as it conforms to a purpose of the present invention; a thin-film layer formed of an organic matter such as phenanthroline or bathocuproine, or an inorganic compound, such as LiF or TiOₓ, may be used.

### (A method for fabricating a photoelectric conversion element)

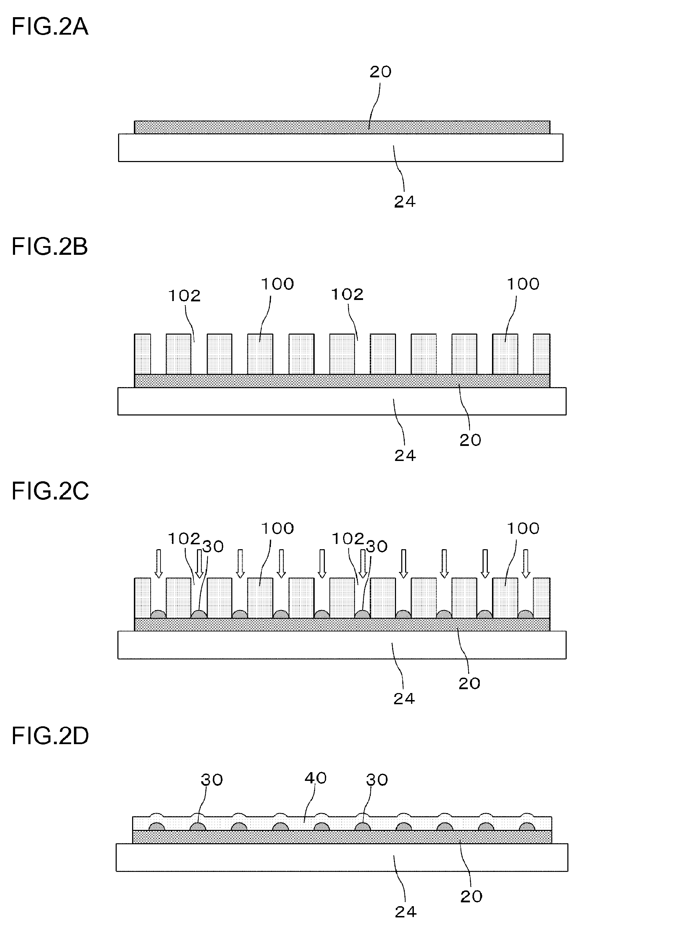

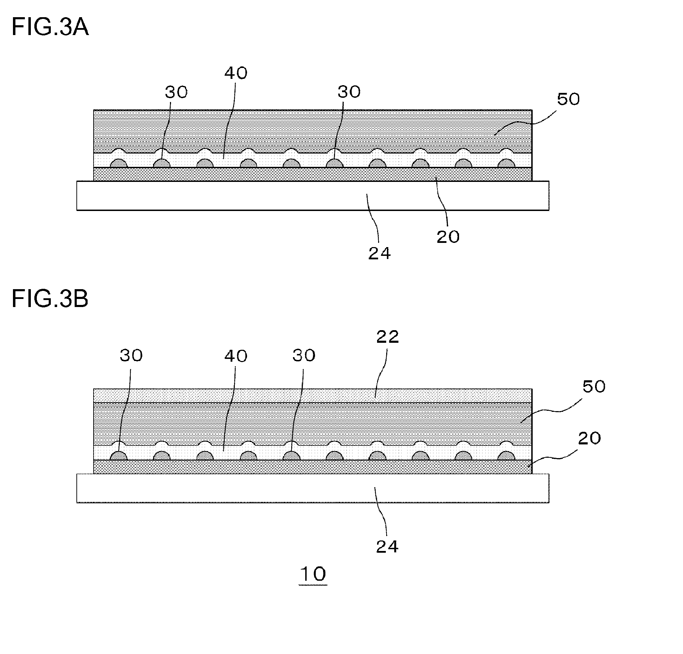

FIGS. 2A to 2D and FIGS. 3A and 3B are cross-sectional views showing processes in a method for fabricating a photoelectric conversion element according to the first embodiment. A description is hereinbelow given of such a method for fabricating the photoelectric conversion element according to the first embodiment.

As illustrated in FIG. 2A, a transparent conductive film such as ITO is first formed on one face of a glass substrate, such as the substrate 24, as the first electrode 20.

Then, as illustrated in FIG. 2B, a mask 100 is formed on an exposure surface of the first electrode 20. A plurality of openings 102, through which a metallic nanoparticle formation region is exposed on the exposed surface (on a side opposite to a substrate 24 side) of the first electrode 20, are formed in the mask 100. The mask 100 may be fabricated as follows, for instance. That is, the surface of an aluminum substrate is anodically oxidized, and then the aluminum substrate excluding the anodically-oxidized part (porous alumina film) is removed and through-holes are formed in the porous alumina film by use of a phosphoric acid solution. Besides this method, the mask 100 can be fabricated as a resist whose predetermined openings has been patterned. Using the thus patterned resist as the mask 100 enables the metallic nanoparticles to be regularly arranged in two dimensions.

Then, as illustrated in FIG. 2C, a metal, such as Ag, Al, Au, or Cu, or an alloy of an alloy of any combination of these metals is deposited over the exposed surface of the first electrode 20 through the mask 100 by use of the vacuum evaporation method. The metallic particles, which have passed through the openings 102 formed in the mask 100, are selectively deposed on exposed portions the first electrode 20 in the openings 102. Thereby, the metallic nanoparticles 30 are formed in the openings 102, and a plurality of metallic nanoparticles 30 are arranged two-dimensionally on the exposed surface of the first electrode 20. The size of the metallic nanoparticle 30 where viewed planarly from a direction perpendicular to the plane of the first electrode 20 is defined by the size of openings 102 formed in the mask 100. Where the mask 100 is formed using the porous alumina film, the size of the opening 102 is proportional to the voltage applied when the aluminum is anodically oxidized. If, for example, a voltage of 40 V is applied to the aluminum substrate using an oxalis acid electrolytic solution of concentration 0.3 mol/L, the size of the opening 102 will be about 50 nm and the size of the metallic nanoparticle 30 will be about 50 nm as well. Also, the height of the metallic nanoparticles measured above the exposed surface of the first electrode 20 can be controlled by varying the time duration of the vacuum evaporation. If the time duration of the vacuum evaporation is short, the metallic nanoparticle 30 will be of a semispherical shape where the sphere is convex along a direction that moves away from the exposed surface of the first electrode 20. And if the time duration of the vacuum evaporation is sufficiently long, the metallic nanoparticle 30 will be of a cylindrical or prismatic shape or of a filler shape.

Then, as illustrated in FIG. 2D, the mask 100 is removed and then a hole transport layer is stacked, as the isolation layer 40, on the surface of the metallic nanoparticles 30 in such a manner as to cover the surface of the metallic nanoparticles 30. A method for laminating the isolation layer 40 is not particularly limited and may, for instance, be a method whereby a hole transport layer is formed into a film using a spin coating technique. In this case, the film thickness of the isolation layer 40 can be controlled by the concentration of a coating liquid including the hole transport layer and a spin coating condition.

Then, as illustrated in FIG. 3A, a photoelectric conversion layer 50 is formed on top of the isolation layer 40. More specifically, the photoelectric conversion layer 50 is formed such that a mixed solution, in which a p-type organic semiconductor such as poly(3-hexylthiophene) and an n-type organic semiconductor such as PCBM are dissolved into a solvent such as dichlorobenzene, is formed into a film using the spin coating technique.

Then, as illustrated in FIG. 3B, a LiF layer whose thickness is 0.5 nm and an Al layer whose thickness is 100 nm are evaporated on top of the photoelectric conversion layer 50 so as to form a second electrode 22.

By employing the photoelectric conversion element 10 according to the above-described first embodiment, the electric field enhancement effect on account of the metallic nanoparticles is markedly produced, so that the utilization efficiency of solar energy can be further improved.

### (Second Embodiment)

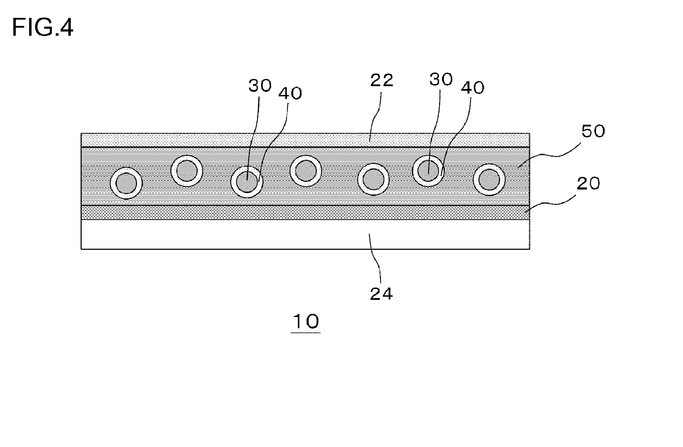

FIG. 4 is a schematic cross-sectional view showing a structure of a photoelectric conversion element 10 according to a second embodiment. The metallic nanoparticles 30 are embedded in the photoelectric conversion layer 50. The shape of each metallic nanoparticle 30 is a spherical form, and the isolation layer 40 covers the metallic nanoparticles 30 on their peripheries.

The isolation layer 40 is formed of, for instance, an organic molecule having a long-chain alkyl group with a functional group, such as an amino group or a thiol group, which is apt to be adsorbed on the surface of the metallic nanoparticles, a polymer material, and a transparent inorganic material, for instance. The polymer material as used herein includes polyethylene terephthalate, polycarbonate, polymethylmethacrylate, polyethylene, polypropylene, ethylene-vinyl acetate copolymer, polystyrene, polyimide, polyamide, polybutylene terephthalate, polyethylene naphthalate, polysulfone, polyether sulfone, polyether ether ketone, polyvinyl alcohol, polyvinyl chloride, polyvinylidene chloride, triacetylcellulose, polyurethane, and cycloolefin polymer, for instance. The transparent inorganic material as used herein includes calcium fluoride, magnesium fluoride, barium fluoride, lithium fluoride, silicon carbide, sapphire, alumina, crystal, fluorine resin, SnO₂, fluorine-doped tin oxide (FTO), ITO, ZnO, SiO₂, TiO₂, ZrO₂, Mn₃O₄, Y₂O₃, WO₃, Nb₂O₂, La₂O₃, and Ga₂O₃, for instance. Similar to the first embodiment, the film thickness of the isolation layer 40 may be 2 nm to 15 nm. The metallic nanoparticles 30 are separated from the photoelectric conversion layer 50 by as much as the film thickness of the isolation layer 40.

By employing the photoelectric conversion element 10 according to the second embodiment, the metallic nanoparticles 30 embedded in the photoelectric conversion layer 50 are separated from the photoelectric conversion layer 50 by the isolation layer 40 by 2 nm to 15 nm. Hence, similar to the first embodiment, the utilization efficiency of solar energy can be further improved.

Note that, in the second embodiment, a hole transport layer or electron transport layer may be provided between the first electrode 20 and the photoelectric conversion layer 50, as necessity arises.

### (Exemplary embodiment 1)

ITO (first electrode) having a surface resistance of 15 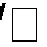 /sq is formed into a film on a cleansed glass substrate.

An alumina mask is obtained as follows. An aluminum substrate is first anodically oxidized on the surface at 16 V in a sulfate electrolytic solution of 8 mol/L. Then the aluminum substrate excluding the oxidized surface (barrier layer) is removed. Then a number of holes formed in the barrier layer are sunk into a phosphoric acid aqueous solution diluted 20-fold with water. An average pore diameter of the thus obtained alumina mask is 20 nm, and a hole density thereof is 7*10¹⁰/cm².

Metallic nanoparticles are formed by vacuum-evaporating Al through the obtained alumina mask on the glass substrate where ITO has been formed. The average particle size of the thus obtained metallic nanoparticles is similar to the average pore diameter of the alumina mask obtained, namely 20 nm.

Subsequently, Baytron P (manufactured by H.C. Starck, Ltd.) is spin-coated onto ITO, where the metallic nanoparticles have been formed, so as to form a hole transport layer and then the thus formed hole transport layer is dried for 10 minutes at 120 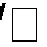 C. The film thickness was controlled to be 12 nm by regulating the solution concentration and the spin coating condition.

Subsequently, poly(3-hexylthiophene), made by Aldrich Chemical Company, Ltd., whose molecular weight is 17,500 is used as the p-type organic semiconductor while PCBM (manufactured by Frontier Carbon, Corp.) is used as the n-type organic semiconductor. And a mixture of poly(3-hexylthiophene) and PCBM are fabricated such that the mass ratio of them is 1:1. And the mixture obtained such that the concentration is 1 wt% is now dissolved in dichlorobenzene so as to obtain a mixed solution (hereinafter referred to as "mixed solution for the photoelectric conversion layer").

Then, the aforementioned mixed solvent is applied on top of the hole transport layer and thereafter it is spin-coated at 800 rpm (10 seconds). This forms a photoelectric conversion layer (bulk heterojunction layer) whose film thickness is 200 nm.

A laminated body comprising a photoelectric conversion layer, a hole transport layer, metallic nanoparticles, ITO, and a glass substrate is dried under nitrogen overnight. Then LiF and Al, whose respective thicknesses are 0.5 nm and 100 nm, are evaporated on the exposed surface of the photoelectric conversion layer under vacuum of about 10⁻⁵ torr, thereby forming a second electrode.

Through the processes as described above, an organic thin-film solar cell is fabricated as the photoelectric conversion element of the exemplary embodiment 1. The thus obtained photoelectric conversion element is encapsulated under nitrogen by use of a glass plate and an epoxy sealing member. Note that the metallic nanoparticles are separated from the photoelectric conversion layer by the hole transport layer by 12 nm. Also, the total volume of metallic nanaoparticles relative to the volume of the photoelectric conversion layer is 0.8 vol%.

### (Exemplary embodiment 2)

The photoelectric conversion element of exemplary embodiment 2 is fabricated using a procedure similar to that of the exemplary embodiment 1 excepting a method for fabricating the metallic nanoparticles. More specifically, an aluminum substrate is anodically oxidized at 25 V in a sulfate electrolytic solution of 0.3 mol/L, thereby obtaining an alumina mask whose average pore diameter is 35 nm. Al is evaporated on ITO through this alumina mask, thereby forming the metallic nanoparticles whose average particle size is 35 nm. In an evaporation process of metallic nanoparticles, control is performed such that the height of the metallic particles is 18 nm.

In the photoelectric conversion element of the exemplary embodiment 2, the metallic nanoparticles are separated from the photoelectric conversion layer by the hole transport layer by 12 nm. Also, the total volume of metallic nanaoparticles relative to the volume of the photoelectric conversion layer is 1.4 vol%.

### (Comparative example 1)

The photoelectric conversion element of comparative example 1 is fabricated using a procedure similar to that of the exemplary embodiment 1 excepting that the formation of metallic nanoparticles is omitted. The structure of layers of the photoelectric conversion element in the comparative example 1 is comprised of a second electrode, a photoelectric conversion layer (bulk heterojuntion layer), a hole transport layer, ITO, and a glass substrate.

### (Comparative example 2)

The photoelectric conversion element of comparative example 2 is fabricated using a procedure similar to that of the exemplary embodiment 1 excepting a method for fabricating the metallic nanopartocles. More specifically, an aluminum substrate is anodically oxidized at 40 V in an oxalis acid electrolytic solution of 0.3 mol/L, thereby obtaining an alumina mask whose average pore diameter is 50 nm. Al is evaporated on ITO through this alumina mask, thereby forming the metallic nanoparticles whose average particle size is 50 nm. In an evaporation process of metallic nanoparticles, control is performed such that the height of the metallic particles is 25 nm.

In the photoelectric conversion element of the comparative example 2, the metallic nanoparticles are separated from the photoelectric conversion layer by the hole transport layer by 12 nm. Also, the total volume of metallic nanaoparticles relative to the volume of the photoelectric conversion layer is 1.9 vol%.

### (Comparative example 3)

The photoelectric conversion element of comparative example 3 is fabricated using a procedure similar to that of the exemplary embodiment 1 excepting that the film thickness of the hole transport layer is 36 nm.

### (Exemplary embodiment 3)

After the cleansing of a glass substrate, ITO (first electrode) having a surface resistance of 15 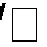 /sq is formed into a film on the glass substrate. Subsequently, Baytron P (manufactured by H.C. Starck, Ltd.) is spin-coated onto ITO so as to form a hole transport layer and then the thus formed hole transport layer is dried for 10 minutes at 120 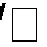 C. The film thickness was controlled to be 36 nm by regulating the solution concentration and the spin coating condition.

A mixed liquid is produced by mixing 100 mL oleylamine and 400 mL liquid paraffin together. 5 g silver nitrate is added to the thus obtained mixed liquid and then the mixed liquid added with silver nitrate is heated at 180 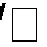 C for two hours and is kept intact at 150 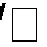 C for five hours. After the mixed liquid added with nitrate is cooled at room temperature, 1500 mL ethanol is added to it. Then, centrifugal separation is repeated three times and is dried in a vacuum. This produces powders composed of metallic nanoparticles (oleylamine-ligand Ag nanoparticles) covered with oleylamine (isolation layers) whose average film thickness is 2 nm. The shape of each metallic nanoparticle thus obtained is a spherical form and the average particle size thereof is 10 nm.

7.3 mg metallic particles obtained are dispersed in 1 mL mixed solution for the photoelectric conversion layer obtained by employing a method similar to that of the exemplary embodiment 1. The thus obtained dispersion liquid is applied on top of the hole transport layer and then it is spin-coated at 800 rpm (10 seconds). This forms a photoelectric conversion layer, whose film thickness is 200 nm, containing the metallic nanoparticles convered with the isolation layers. The total volume of metallic nanoparticles relative to the volume of the photoelectric conversion layer is 2.0 vol%.

A laminated body comprising a photoelectric conversion layer (having the metallic nanoparticles therein covered with the isolation layers), a hole transport layer, ITO, and a glass substrate is dried under nitrogen overnight. Then LiF and Al, whose respective thicknesses are 0.5 nm and 100 nm, are evaporated on the exposed surface of the photoelectric conversion layer under vacuum of about 10⁻⁵ torr, thereby forming a second electrode.

Through the processes as described above, an organic thin-film solar cell is fabricated as the photoelectric conversion element of the exemplary embodiment 3. The thus obtained photoelectric conversion element is encapsulated under nitrogen by use of a glass plate and an epoxy sealing member.

### (Exemplary embodiment 4)

The photoelectric conversion element of exemplary embodiment 4 is fabricated using a procedure similar to that of the exemplary embodiment 3 excepting a method for fabricating the metallic nanoparticles covered with isolation layers.

100 mg powders composed of metallic nanoparticles covered with oleylamine whose average film thickness is 2 nm obtained by employing a method similar to that of the exemplary embodiment 3 are dispersed in 10 mL hexane. This dispersion liquid is added to a mixed liquid of 2500 ml propanol and 250 ml water, and then 1 mL tetraethoxysilane and 40 mL ammonia solution (concentration: 30%) are further added to the mixed liquid thereof added with the dispersion liquid and then stirred. This forms SiO₂ layers on the surface of the metallic nanoparticles. The thickness of the SiO₂ layer is controlled by reaction time. After the reaction, they are subjected to centrifugal separation and are dried in a vacuum, thereby obtaining metallic nanoparticles covered with the SiO₂ layers whose average thickness is 10 nm.

30 mg metallic particles obtained are dispersed in 1 mL mixed solution for the photoelectric conversion layer obtained by employing a method similar to that of the exemplary embodiment 1. The thus obtained dispersion liquid is applied on top of the hole transport layer and then it is spin-coated at 800 rpm (10 seconds). This forms a photoelectric conversion layer, whose film thickness is 200 nm, containing the metallic nanoparticles covered with the isolation layers. The total volume of metallic nanaoparticles relative to the volume of the photoelectric conversion layer is 1.8 vol%.

### (Exemplary embodiment 5)

The photoelectric conversion element of comparative example 5 is fabricated using a procedure similar to that of the exemplary embodiment 4 excepting that the total volume of metallic nanaoparticles relative to the volume of the photoelectric conversion layer is 1.0 vol%.

### (Exemplary embodiment 6)

The photoelectric conversion element of exemplary embodiment 5 is fabricated using a procedure similar to that of the exemplary embodiment 4 excepting that the total volume of metallic nanaoparticles relative to the volume of the photoelectric conversion layer is 3.0 vol%.

### (Comparative example 4)

The photoelectric conversion element of comparative example 4 is fabricated using a procedure similar to that of the exemplary embodiment 3 excepting a method for fabricating the metallic nanoparticles covered with isolation layers.

100 mg powders composed of metallic nanoparticles covered with oleylamine whose average film thickness is 2 nm obtained by employing a method similar to that of the exemplary embodiment 3 are dispersed in 1 mL butylamine solution and stirred for eight hours. Then, methanol is added to the mixed solution and then centrifugal separation is repeated three times and is dried in a vacuum. Thereby, powers of metallic nanoparticles (butylamine-ligand Ag nanoparticles) convered with 1 nm butylamine whose average film thickness are obtained.

7.3 mg metallic particles obtained are dispersed in 1 mL mixed solution for the photoelectric conversion layer obtained by employing a method similar to that of the exemplary embodiment 1. The thus obtained dispersion liquid is applied on top of the hole transport layer and then it is spin-coated at 800 rpm (10 seconds). This forms a photoelectric conversion layer, whose film thickness is 200 nm, containing the metallic nanoparticles covered with the isolation layers. The total volume of metallic nanaoparticles relative to the volume of the photoelectric conversion layer is 2.0 vol%.

### (Comparative example 5)

The photoelectric conversion element of comparative example 5 is fabricated using a procedure similar to that of the exemplary embodiment 4 excepting that the total volume of metallic nanaoparticles relative to the volume of the photoelectric conversion layer is 1.8 vol% and that the average thickness of the SiO₂ layer covering the metallic nanoparticle is 20 nm.

### (Comparative example 6)

The photoelectric conversion element of comparative example 6 is fabricated using a procedure similar to that of the exemplary embodiment 4 excepting that the total volume of metallic nanaoparticles relative to the volume of the photoelectric conversion layer is 0.3 vol% and that the average thickness of the SiO₂ layer covering the metallic nanoparticle is 10 nm.

### (Comparative example 7)

The photoelectric conversion element of comparative example 7 is fabricated using a procedure similar to that of the exemplary embodiment 4 excepting that the total volume of metallic nanaoparticles relative to the volume of the photoelectric conversion layer is 3.5 vol% and that the average thickness of the SiO₂ layer covering the metallic nanoparticle is 10 nm.

**[Table 1]**

| | METALLIC NANOPARTICLE | | | HOLE TRANSPORT LAYER | PHOTOELECTRIC CONVERSION LAYER | RELATIVE CURRENT VALUE |
|---|---|---|---|---|---|---|
| | METAL | SIZE | Vol% | THICKNESS | THICKNESS | |
| EXEMPLARY EMBODIMENT 1 | Al | DIAMETER 20nm HEIGHT 10nm | 0.8% | 12nm | 200nm | 1.07 |
| EXEMPLARY EMBODIMENT 2 | Al | DIAMETER 35nm HEIGHT 18nm | 1.4% | 12nm | 200nm | 1.05 |
| COMPARATIVE EXAMPLE 1 | - | - | - | 12nm | 200nm | 1 |
| COMPARATIVE EXAMPLE 2 | Al | DIAMETER 50nm HEIGHT 25nn | 1.9% | 12nm | 200nm | 0.8 |
| COMPARATIVE EXAMPLE 3 | Al | DIAMETER 20nm HEIGHT 10nm | 0.8% | 36nm | 200nm | 0.98 |

**[Table 2]**

| | METALLIC NANOPARTICLE | | | ISOLATION LAYER | | PHOTOELECTRIC CONVERSION LAYER | RELATIVE CURRENT VALUE |
|---|---|---|---|---|---|---|---|
| | METAL | SIZE | Vol% | SUBSTANCE | AVERAGE THICKNESS | THICKNESS | |
| EXEMPLARY EMBODIMENT 3 | Ag | DIAMETER 10nm | 2.0% | OLEYLAMINE | 2nm | 200nm | 1.1 |
| EXEMPLARY EMBODIMENT 4 | Ag | DIAMETER 10nm | 1.8% | SiO₂ | 10nm | 200nm | 1.08 |
| EXEMPLARY EMBODIMENT 5 | Ag | DIAMETER 10nm | 1.0% | SiO₂ | 10nm | 200nm | 1.05 |
| EXEMPLARY EMBODIMENT 6 | Ag | DIAMETER 10nm | 3.0% | SiO₂ | 10nm | 200nm | 1.04 |
| COMPARATIVE EXAMPLE 4 | Ag | DIAMETER 10Nm | 2.0% | BUTYLAMINE | 1nm | 200nm | 0.21 |
| COMPARATIVE EXAMPLE 5 | Ag | DIAMETER 10nm | 1.8% | SiO₂ | 20nm | 200nm | 0.96 |
| COMPARATIVE EXAMPLE 6 | Ag | DIAMETER 10nm | 0.3% | SiO₂ | 10nm | 200nm | 0.99 |
| COMPARATIVE EXAMPLE 7 | Ag | DIAMETER 10nm | 3.5% | SiO₂ | 10nm | 200nm | 0.9 |

### (Measurement of absorption wavelength)

A photoelectric conversion layer similar to those of the exemplary embodiment 1 and the comparative example 1 is formed into a film on an ITO substrate. The absorption spectra of this photoelectric conversion layer was measured using a Hitachi spectrophotometer U-4100. The result indicated that the absorption peak of the photoelectric conversion layer lies near 520 nm. Also, metallic particles mainly composed of Al similar to those of the exemplary embodiment 1 were formed on the ITO substrate. The absorption spectra of the metallic nanoparticles was measured using the Hitachi spectrophotometer U-4100. The result indicated that the absorption peak of the metallic nanoparticles mainly composed of Al lies near 340 nm and is therefore shorter in wavelength than the absorption peak of the photoelectric conversion layer. Also, metallic nanoparticles mainly composed of Ag similar to those of the exemplary embodiment 3 were dispersed in 1 mL hexane. The absorption spectra of this dispersion liquid was measured using the Hitachi spectrophotometer U-4100. The result indicated that the absorption peak of the metallic nanoparticles mainly composed of Ag lies near 410 nm and is therefore shorter in wavelength than the absorption peak of the photoelectric conversion layer.

### (Evaluation of quantum yield)

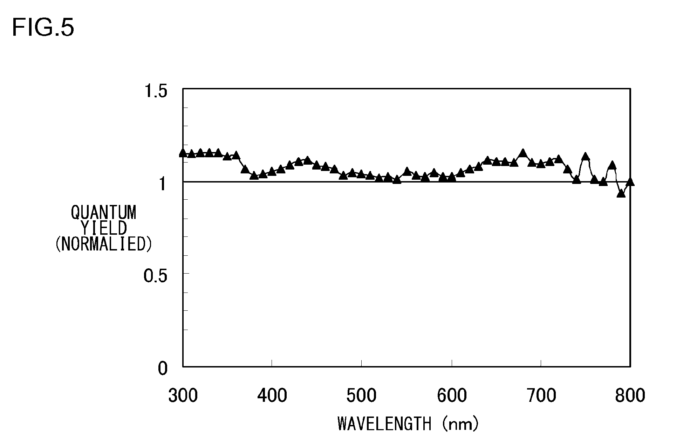

FIG. 5 is a graph showing a quantum yield at each wavelength in a visible light wavelength region about a photoelectric conversion element where the quantum yield of a photoelectric conversion element according to the comparative example 1 is set to unity. The quantum yields are calculated as follows. A two-lamp system of xenon lamp and halogen lamp is used and the element is irradiated with a monochromatic light of 300 to 800 nm wavelength dispersed by a monochromator in an AC mode. Then the quantum yield is calculated from the number of irradiated photons at each wavelength and a photoelectric current value. As evident from FIG. 5, the quantum yields of the photoelectric conversion element according to the exemplary embodiment 1 were improved, in the visible light region, over those of the comparative example 1. This verifies that the light absorption characteristic of the metallic nanoparticles has increased.

### (Evaluation of light absorptance)

The voltage-current characteristics of the photoelectric conversion elements are measured while the simulated solar light whose energy density is 100 mW/cm² is irradiated, and then the short-circuit current values are compared among the respective photoelectric conversion elements according to the exemplary embodiments 1 to 6 and the comparative examples 1 to 7. Table 1 shows the short-circuit current values of the photoelectric conversion elements according to the exemplary embodiment 1 to 6 and the comparative examples 2 to 7, when the short-circuit current of the photoelectric conversion element according to the comparative example 1 having no metallic nanoparticles is set to unity.

### (Evaluation results)

It was verified that the relative current values increase in the photoelectric conversion elements of the exemplary embodiments 1 and 2 where the average particle size of the metallic nanoparticles is 40 nm or below. In contrast thereto, it is verified that the relative current value has decreased in the photoelectric conversion element of the comparative example 2 where the average particle size of the metallic nanoparticles exceeds 40 nm. This shows that the value of current flowing when light is received drops in the photoelectric conversion element whose average particle size of the metallic nanoparticles is 40 nm or above. It is speculated that this phenomenon is caused because the metallic nanoparticles absorb light and are thermally deactivated.

In the photoelectric conversion element of the comparative example 2 where the distance between the metallic nanoparticles and the photoelectric conversion layer is greater than 15 nm, the relative current value is 0.98 and therefore no increase in current value is observed over that of the photoelectric conversion element of the comparative example 1. Also, in the photoelectric conversion element of the comparative example 5 where the distance between the metallic nanoparticles and the photoelectric conversion layer is greater than 15 nm, the current value became slightly smaller than that of the comparative example 1. In contrast thereto, in the photoelectric conversion element of the exemplary embodiment 4 where the distance between the metallic nanoparticles and the photoelectric conversion layer is 10 nm, the relative current value increased over that of the comparative example 1. This may be inferred as follows. The electric field enhancement effect on account of the metallic nanoparticles may be degraded when the metallic nanoparticles are spaced apart from the photoelectric conversion layer more than necessary.

In the photoelectric conversion element of the comparative example 4 where the distance between the metallic nanoparticles and the photoelectric conversion layer is less than 2 nm, the relative current value dropped to an extremely low level. In contrast thereto, in the photoelectric conversion element of the exemplary embodiment 3 where the distance between the metallic nanoparticles and the photoelectric conversion layer is 2 nm, the current value increased over that of the comparative example 1. The reason for this may be inferred as follows. If the metallic nanoparticles are located closer to the photoelectric conversion layer than necessary, the metallic nanoparticles may act as the recombination center of carriers and part of positive holes disappear.

It was verified that the relative current values become greater than "1" in the exemplary embodiments 3 to 6 where the total volume of metallic nanoparticles is 0.5 to 3 vol%. In contrast thereto, in the comparative example 6 where the total volume of metallic nanaoparticles is less than 0.5 vol%, the current value is almost equal to that of the comparative example 1. Also, in the comparative example 7 where the total volume of metallic nanaoparticles is greater than 3 vol%, the current value is reduced over that of the comparative example 1. It was therefore verified that when the total volume of metallic nanaoparticles relative to the volume of the photoelectric conversion layer is outside the range of 0.5 to 3 vol%, the effect of increasing the current value on account of the metallic nanoparticles is degraded. If the total volume of metallic nanaoparticles is less than 0.5 vol%, it may be inferred that the electric field enhancement effect on account of the metallic nanoparticles is not sufficiently achieved. If, on the other hand, the total volume of metallic nanaoparticles is greater than 3 vol%, it may be inferred that reduction in the ratio of the photoelectric conversion layer over the photoelectric conversion element as a whole reduces the current value.

The present invention is not limited to the above-described embodiments only. It is understood that various modifications such as changes in design may be made based on the knowledge of those skilled in the art, and the embodiments added with such modifications are also within the scope of the present invention.

For example, in the above-described first embodiment, the first electrode is an anode, and the isolation layer is a hole transport layer. However, the first electrode may be a cathode, and the isolation layer may be an electron transport layer. Also, the isolation layer of the first embodiment may be of a stacked structure comprised of a hole transport layer and an electron transport layer.

Furthermore, the following stacked structures (a), (b) and (c) each comprised of the following components may serve as modifications to the first embodiment.
(a): a first electrode, metallic nanoparticles, a first hole transport layer (isolation layer), a second hole transport layer (isolation layer), a photoelectric conversion layer, and a second electrode.
(b): a first electrode, metallic nanoparticles, a first hole transport layer (isolation layer), a second hole transport layer (isolation layer), a photoelectric conversion layer, an electron transport layer, and a second electrode.
(c): a first electrode, metallic nanoparticles, a first hole transport layer (isolation layer), a photoelectric conversion layer, a first electron transport layer, a second electron transport layer, and a second electrode.

### [DESCRIPTION OF THE REFERENCE NUMERALS]

- 10: Photoelectric conversion element
- 20: First electrode
- 22: Second electrode
- 24: Substrate
- 30: Metallic nanoparticles
- 40: Isolation layer
- 50: Photoelectric conversion layer

### [INDUSTRIAL APPLICABILITY]

The present invention is applicable to a photoelectric conversion element that converts light energy into electric energy by photoelectric conversion.

## Claims

1. A photoelectric conversion element comprising:
a photoelectric conversion layer including organic semiconductor;
metallic nanoparticles;
an isolation layer held between the nanoparticles and the photoelectric conversion layer;
a first electrode electrically connected to the photoelectric conversion layer on a side of a light-receiving surface of the photoelectric conversion layer; and
a second electrode electrically connected to the photoelectric conversion layer on a side of the photoelectric conversion layer opposite to the light-receiving surface thereof,
wherein the metallic nanoparticles are separated from the photoelectric conversion layer by the isolation layer by 2 nm to 15 nm.

2. A photoelectric conversion element according to claim 1, wherein the isolation layer is provided on the light-receiving surface of the photoelectric conversion layer, and
wherein the metallic nanoparticles are provided on a surface of the isolation layer opposite to a surface thereof on a photoelectric conversion layer side.

3. A photoelectric conversion element according to claim 2, wherein the isolation layer is a charge transport layer.

4. A photoelectric conversion element according to claim 1, wherein the metallic nanoparticles are embedded in the photoelectric conversion layer, and
wherein the isolation layer covers the metallic nanoparticles on a periphery thereof.

5. A photoelectric conversion element according to any one of claim 1 to claim 4, wherein an average particle size of the metallic nanoparticle is 40 nm or blow.

6. A photoelectric conversion element according to any one of claim 1 to claim 5, wherein a total volume of the metallic nanoparticles over a volume of the photoelectric conversion layer is in a range of 0.5 to 5 vol%.

7. A photoelectric conversion element according to any one of claim 1 to claim 6, wherein a light absorption peak wavelength 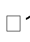 1 is larger than a surface plasmon resonance wavelength 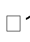 2.

8. A photoelectric conversion element according to any one of claim 1 to claim 7, wherein the photoelectric conversion layer is a bulk heterojunction layer.
